# EUROPEAN PATENT APPLICATION

(11) **EP 4 745 608 A1**
(43) Date of publication of application: **20.05.2026**
(21) Application number: 24213196.9
(22) Date of filing: 15.11.2024
(51) Int. Cl.: G01R 31/58, G01R 31/69

(54) **TEST ADAPTER FOR TESTING A WIRE HARNESS**

(71) Applicant: Komax Testing Germany GmbH, 32457 Porta Westfalica (DE)
(72) Inventor: Nagel, Norman, 32457 Porta Westfalica (DE); Bonifácio, Eugénio Pereira, 32469 Petershagen (DE)
(74) Representative: Scheidiger, Michael

(57) **Abstract**

The invention relates to a test adapter for testing a wire harness on a wiring board, the wiring harness comprising a plurality of wires connected between a plurality of wiring connectors, the wiring connectors comprising respectively at least one electric wire terminal associated with at least one of the wires. The test adapter can comprise a base unit and a testing connector, the testing connector being configured to receive a respective one of the wiring connectors, the testing connector having at least one testing terminal configured for being electrically connected to the at least one electric wire terminal of the respective wiring connector. The base unit can be configured to be assembled in a basic state and in an extended state. In the basic state the base unit can comprise a communication module and a testing module. In the extended state, the base unit can comprise the communication module, the testing module, and at least one further functional module.

## Description

Wire harnesses are for instance commonly used in automobiles and can transmit electrical energy and/or signals. A wire harness comprises a plurality of wires (cables) which can be connected (assembled) according to a particular assembly scheme. For proper functioning of the wire harness, each individual connection in the wire harness has to work properly (correctly).

Before the wire harness is installed, e.g., in the automobile, it has to be ensured that the wire harness works properly. A test adapter can be used to test the wire harness, particularly the connections and/or wires within the wire harness.

Depending on the particular connection, different characteristics can be tested. Different adapters can be configured for the testing of the different characteristics. This can lead to high costs for users.

Therefore, there is a need for a test adapter capable for testing of different characteristics.

This problem is solved by the test adapter of claim 1, the method of claim 11 and the use of claim 13. Further embodiments are given in the dependent claims and/or described below.

A first aspect of the invention relates to a test adapter for testing a wire harness on a wiring board, the wiring harness comprising a plurality of wires connected between a plurality of wiring connectors, the wiring connectors comprising respectively at least one electric wire terminal associated with at least one of the wires. The test adapter can comprise a base unit and a testing connector. The testing connector can be configured to receive a respective one of the wiring connectors, the testing connector having at least one testing terminal configured for being electrically connected to the at least one electric wire terminal of the respective wiring connector. The base unit can be configured to be assembled in a basic state and in an extended state. In the basic state, the base unit can comprise: a communication module, wherein the communication module is configured for communication with a communication hub, and a testing module connected to the at least one testing terminal for passing an electric testing signal to the at least one testing terminal and/or for obtaining an electric testing signal from the at least one testing terminal. In the extended state, the base unit can comprise the communication module, the testing module, and at least one further functional module.

The base unit can be configured to be re-configured. The base unit can be convertible (transferable, modifiable, transformable) from the basic state into the extended state. The base unit can be convertible from the extended state into the basic state. The base unit can be scaled up depending on the particular requirements for testing the wire harness. For instance, additional functionalities, e.g. testing opportunities and/or a power supply, can be added. The base unit can be scaled down depending on the particular requirements for testing the wire harness. For instance, functionalities, e.g. the power supply, can be removed.

The base unit can be present in the basic state. From the basic state, the base unit can be re-configured into the extended state. At least one functional module can be added to the base unit in the basic state such that the base unit is transferred into the extended state.

The base unit can be present in the extended state. From the extended state, the base unit can be re-configured into the basic state. At least one functional module can be removed from the base unit in the extended state such that the base unit is transferred into the basic state.

In the extended state, the base unit can comprise at least one functional module, which is configured to execute at least one additional functionality. The functional module can be configured to perform a measurement. The functional module can be configured for analysis. The functional module can provide a power supply.

The base unit in the basic state can comprise modules required for the basic processes (basic functions, basic functionality). The basic functions can comprise testing by the testing module. The basic functions can comprise communicating by the communication module. The basic functions can be the essential functions for testing of the wire harness. The basic functions can be the functions of the test adapter that are required for each testing of the wire harness.

The testing module can be an essential module. The communication module can be an essential module. The testing module and the communication module can be essential modules. In an embodiment, the base unit in the basic state comprises the essential modules. In an embodiment, the base unit in the extended state comprises the essential modules. In an embodiment, the base unit in the basic state and in the extended state comprises the essential modules.

The testing module can comprise a test point card. The testing module can be connected to the at least one testing terminal for passing an electric testing signal to the at least one testing terminal. The testing module can be connected to the at least one testing terminal for obtaining an electric testing signal from the at least one testing terminal. The testing module can be connected to the at least one testing terminal for passing an electric testing signal to the at least one testing terminal, and for obtaining an electric testing signal from the at least one testing terminal.

In an embodiment, the testing module can comprise a processing unit. The testing module can comprise a printed circuit board (PCB). In an embodiment, the testing module can comprise a single-board computer. In an embodiment, the testing module can comprise a Raspberry Pi.

The base unit in the extended state can comprise modules required for the basic processes. The modules in the extended state can comprise further functional modules configured for additional test processes, such as a sensor. The modules in the extended state can comprise further functional modules that can be scaled up, e.g. further testing modules. The modules in the extended state can comprise further functional modules configured for additional functionalities, such as a power source (power supply) to provide power to the test adapter.

The state of the base unit can be tailored for the particular test scenario considered for the particular connection in the particular wire harness. The composition of the extended state can be tailored for the particular test scenario considered for the particular wire harness.

An advantage can be that the base unit comprises only components necessary for the particular wire harness testing (particularly testing of the connections). Components not needed for the particular harness testing can be left out. Non-essential components for the particular harness testing can be left out. The test adapters can be simplified.

In an embodiment, the base unit can be assembled according to a modular principle. The base unit can be put together from modular components that can be re-combined repeatedly. Modular components, particularly further functional modules, that are not needed for a particular testing can be left out. Modular components, particularly further functional modules, required for a specific test can be specifically included in the respective test adapter, particularly the respective base unit, for that purpose.

Advantageously, the base unit can be specifically equipped depending on the particular testing requirements.

In an embodiment, the testing of the wire harness can require different types of test adapters. For instance, one test adapter may require an additional functioning. The base units of the test adapters for that specific test can be configured accordingly. For instance, the one test adapter may comprise the base unit in the extended state, while all other test adapters can comprise base units in the basic state. An advantage can be that it would not be necessary to provide all test adapters with base units in the extended state when only one (or a subset) test adapter requires the additional functioning of the extended state. Advantageously, resources can be saved.

In an embodiment, the test adapter can be configured for in-line testing of the wire harness. The test adapter can be configured for testing the wire harness during assembly of the wire harness. An advantage can be that the testing of the wire harness can be improved.

In an embodiment, the wiring board can comprise or consist of a wire assembly board.

The wire harness (cable harness, wiring harness, cable assembly, wire assembly) can comprise a plurality of wires. The plurality of wires can include a cable, particularly a plurality of cables. The wires of a wire harness can be bound together. In an embodiment, the wire harness can comprise an optical fibre.

The wires of the wire harness can be connected between a plurality of wiring connectors. Each wire of the wire harness can be associated with at least one electric wire terminal. In an embodiment, each wire of the wire harness is associated with a respective first electric wire terminal and an opposite respective second electric wire terminal. The respective wire can extend between the first electric wire terminal and the second electric wire terminal. The respective wire terminal can be associated with the respective wiring connector. The wiring connectors can comprise at least one electric wire terminal associated with at least one of the wires.

In an embodiment, the at least one further functional module is at least one of: a further testing module, a power source, a functional testing unit configured for performing a further functional test on the at least one electric wire terminal and/or on the at least one of the wires.

The further functional module can comprise the further testing module. The further functional module can comprise the power source. The further functional module can comprise functional testing unit configured for performing a further functional test on the at least one electric wire terminal and/or on the at least one of the wires. The further functional module can comprise a further test point card.

The power source can be arranged and configured to power the test adapter. The power source can be arranged and configured to power the testing connector. The power source can be arranged and configured to power the base unit. The power source can be arranged and configured to power the testing module of the base unit. The power source can be arranged and configured to power the communication module. The power source can be arranged and configured to power an additional further functional module. The power source can be arranged and configured to power the further testing module. The power source can be arranged and configured to power the functional testing unit.

In an embodiment, the powered test adapter (master test adapter) and the power source can be arranged and configured to emit an electric testing signal from the powered test adapter through the wire of the wire harness, and powering, with the electric testing signal from the master test adapter, a test adapter also connected to the respective wire (satellite test adapter; unpowered test adapter). In an embodiment, when the connection via the wire exists, the electrical testing signal can be transferred from the master test adapter to the satellite test adapter. In an embodiment, the power source of the master test adapter can be arranged and configured to power the connected satellite test adapter. The powered test adapter (test adapter and the included power source) can be arranged and configured to power an entity of the connected satellite test adapter. The powered test adapter (test adapter and the included power source) can be arranged and configured to power the testing module of the connected satellite test adapter. The powered test adapter (test adapter and the included power source) can be arranged and configured to power the base unit of the connected satellite test adapter.

The test adapter can be configured as a master test adapter. The test adapter can be configured as a satellite test adapter. One advantage may be that the same basic equipment can be used for both types of test adapters and, depending on requirements, the respective test adapter can be configured as the master test adapter or as the satellite test adapter. The test adapter can be easily configured accordingly, e.g. by including and/or removing the power source.

The further functional module can be included to extend (scale-up) the testing capabilities of the respective test adapter, particularly by including at least one further testing module. Depending on the particular testing requirement, multiple further testing modules can be included in the extended state. The test adapter can be adjusted (customised, adapted) to different requirements. An advantage can be that the test adapter can be re-configured depending on the particular requirements and can be used for different applications. Costs can be reduced.

In an embodiment, the electric testing signal is selected from a constant voltage, a non-constant voltage, a transient voltage, a periodic voltage, a switching on and off of a pre-selected voltage, a switching on of a pre-selected voltage for a pre-determined duration and a switching of after the pre-determined duration.

For each connection, an individual electrical testing signal can be selected. In an embodiment, each connection can be tested with a respective individually selected electric testing signal.

In an embodiment, a common electrical testing signal can be selected wherein each connection can be tested with the same common electrical testing signal. In an embodiment, each connection can be tested with the same selected electric testing signal.

The electrical testing signal can be constant in time. In an embodiment, the electrical testing signal can vary in a time-dependent manner. The electrical testing signal can periodically change.

The electrical testing signal can be tailored for testing the respective connection.

An advantage can be that the testing signal can be specifically selected for the testing of the respective connection. The testing can advantageously be improved.

In an embodiment, the communication module and the communication hub are configured for wireless communication.

The communication module can be configured for wireless communication with the communication hub. The communication hub can be configured for wireless communication with the communication module. In an embodiment, the communication hub can be configured for wireless communication with a plurality of communication modules. The communication hub can be configured for wireless communication with the communication modules of multiple test adapters.

The communication hub can comprise or consist of a wireless communication hub. In an embodiment, the communication module can be configured for wireless communication with a control unit, particularly via a wireless network with a frequency below 1 GHz, particularly between 650 MHz and 700 MHz, particularly 680 MHz.

An advantage can be that a fast communication can be provided.

In an embodiment, the power source can comprise a battery, particularly a re-chargeable battery. In an embodiment, the power source can comprise a capacitor. In an embodiment, the power source can comprise a battery and a capacitor.

In an embodiment, the further functional module can comprise a capacitor.

The capacitor can be transiently chargeable.

An advantage can be that the test adapter can be positioned in any location without the need for access to an external power source. The possible uses can be advantageously increased.

In an embodiment, the power source can be configured to power at least one of the test adapter, the base unit, the testing module, the communication module, and/or the further functional module.

In an embodiment, the power source can be configured to power at least one of a connected test adapter, the base unit of the connected test adapter, the testing module of the connected test adapter, the communication module of the connected test adapter, and/or the further functional module of the connected test adapter.

In an embodiment, the power source can be configured to charge the power source of the connected test adapter. In an embodiment, the power source can be configured to charge the re-chargeable battery of the connected test adapter. In an embodiment, the power source can be configured to charge the capacitor of the connected test adapter. The capacitor of the connected test adapter can be configured to store energy provided by the power source.

The further functional module can comprise a power storage unit. In an embodiment, the power source can comprise a power storage unit. In an embodiment, the power storage unit comprises or consists of the capacitor.

In an embodiment, the base unit can be configured to receive and/or analyse data determined by the further functional module, particularly wherein the testing module and/or the further testing module is configured for receiving and/or analysing data determined by the further functional module.

In an embodiment, the base unit can be configured to receive data determined by the further functional module. In an embodiment, the base unit can be configured to analyse data determined by the further functional module. In an embodiment, the base unit can be configured to receive and analyse data determined by the further functional module.

In an embodiment, the testing module and/or the further testing module can be configured for receiving and/or analysing data determined by the further functional module. In an embodiment, the testing module can be configured for receiving and/or analysing data determined by the further functional module. In an embodiment, the further testing module can be configured for receiving and/or analysing data determined by the further functional module. In an embodiment, the testing module and the further testing module can be configured for receiving and/or analysing data determined by the further functional module.

In an embodiment, the testing module can be configured for receiving data determined by the further functional module. In an embodiment, the testing module can be configured for analysing data determined by the further functional module. In an embodiment, the testing module can be configured for receiving and analysing data determined by the further functional module.

In an embodiment, the further testing module can be configured for receiving data determined by the further functional module. In an embodiment, the further testing module can be configured for analysing data determined by the further functional module. In an embodiment, the further testing module can be configured for receiving and analysing data determined by the further functional module.

In an embodiment, the testing module and the further testing module can be configured for receiving data determined by the further functional module. In an embodiment, the testing module and the further testing module can be configured for analysing data determined by the further functional module. In an embodiment, the testing module and the further testing module can be configured for receiving and analysing data determined by the further functional module.

The testing capabilities of the respective test adapter can be extended by the further testing module.

In an embodiment, the further functional module can comprise at least one of a force sensor, a tensile force sensor, a light source, an analogue input unit.

In an embodiment, the further functional module can comprise a force sensor. In an embodiment, the further functional module can comprise a tensile force sensor. In an embodiment, the further functional module can comprise a light source. In an embodiment, the further functional module can comprise an analogue input unit.

The test adapter can be configured for a tensile test. In the extended state, the test adapter can be configured for the tensile test of the connections within the wire harness. The force sensor can be configured to detect a mechanical strength of the connection. The force sensor can be configured to detect a mechanical strength of the connection between the wire terminal and the respective wiring connector. The tensile force sensor can be configured to detect a mechanical strength of the connection. The tensile force sensor can be configured to detect a mechanical strength of the connection between the wire terminal and the respective wiring connector.

An advantage can be that the test adapter can be configured for additional tests on the connections within the wire harness.

In an embodiment, the wire harness can comprise at least one optical fibre.

The test adapter can be configured for testing an optical fibre. The light source can be arranged and configured to emit a light beam. The light source can be arranged and configured to emit a light pattern. The test adapter can further comprise a light detector arranged and configured to detect the light beam and/or the light pattern. The further functional module can comprise the light detector.

An advantage can be that the test adapter can be configured for additional tests on the connections within the wire harness.

The analogue input unit can be arranged and configured to measure a change in the voltage and/or the current and/or the resistance of the force sensor. The analogue input unit can be arranged and configured to measure a change in the voltage and/or the current and/or the resistance of the tensile force sensor.

The analogue input unit can be arranged and configured to process measurement data of the force sensor. The analogue input unit can be configured to receive and/or transmit data of the force sensor. The analogue input unit can be arranged and configured to process measurement data of the tensile force sensor. The analogue input unit can be configured to receive and/or transmit data of the tensile force sensor.

An advantage can be that the test adapter can be configured for additional tests on the connections within the wire harness.

The further functional modules can increase the testing possibilities. An advantage can be that the possible applications can be increased.

For instance, for new examinations (testing, testing procedures), only new further functional modules would have to be bought; no new test adapters. An advantage can be that costs can be reduced. Advantageously, resources can be saved.

In an embodiment, the base unit can be repeatedly and reversibly transferable from the basic state to the extended state and/or the base unit can be repeatedly and reversibly connectable to the testing connector.

In an embodiment, the base unit can be repeatedly and reversibly transferable from the basic state to the extended state. In an embodiment, the base unit can be repeatedly and reversibly transferable from the extended state to the basic state. In an embodiment, the base unit can be repeatedly and reversibly connectable to the testing connector. In an embodiment, the base unit can be repeatedly and reversibly disconnectable (detachable) from the testing connector.

The base unit can be repeatedly and reversibly connectable to the testing connector, when the base unit is in the basic state. The base unit can be repeatedly and reversibly connectable to the testing connector, when the base unit is in the extended state.

In an embodiment, the base unit and the testing connector can be configured such that the base unit in the basic state can be detachable from the testing connector, the detached base unit can be transferable to the extended state and the base unit in the extended state can be connectable to the testing connector.

In an embodiment, the base unit and the testing connector can be configured such that the base unit in the extended state can be detachable from the testing connector, the detached base unit can be transferable to the basic state and the base unit in the basic state can be connectable to the testing connector.

In an embodiment, independent of the state of the base unit (basic state; extended state), the base unit can be connectable to the same testing connector. The testing connector can be configured for attachment with the base unit in the basic state. The testing connector can be configured for attachment with the base unit in the extended state. The testing connector can be configured for attachment with the base unit in the basic state and for attachment with the base unit in the extended state.

An advantage can be that the same testing connector can be used independent of the particular state of the base unit. Costs can be reduced advantageously.

In an embodiment, the components of the base unit can be re-used. In an embodiment, the components of the base unit can be used repeatedly in different compositions (combinations, configurations). Costs can be reduced. Advantageously, resources can be saved.

In an embodiment, the base unit and the testing connector can be re-used. In an embodiment, the base unit and the testing connector can be used repeatedly in different compositions (combinations, configurations). Costs can be reduced. Advantageously, resources can be saved.

In an embodiment, the test adapter can be assembled according to a modular principle. In an embodiment, the base unit can be assembled according to a modular principle. In an embodiment, the test adapter as well as the base unit of the test adapter each can be assembled according to a modular principle.

Each testing connector can be assemblable to each one base unit, wherein the base unit can be in the basic state. Each testing connector can be assemblable to each one base unit, wherein the base unit can be in the extended state.

In an embodiment, the testing connector can be re-configurable. The testing connector can be configured according to the state of the base unit. In an embodiment, the base unit (state of the base unit) can be configured according to the configuration of the testing connector. The testing connector can comprise one testing terminal. The testing connector can comprise a plurality of testing terminals. In an embodiment, the number of testing modules of the base unit is selected corresponding to the number of testing terminals of the testing connector.

In an embodiment, the test adapter for testing a wire harness on a wiring board can comprise the base unit and the testing connector repeatedly and removably coupled to each other.

In an embodiment, the test adapter can comprise a coupling assembly. The coupling assembly can comprise a first adapter unit arranged or arrangeable at the testing connector and a second adapter unit complementary to the first adapter unit, wherein the second adapter unit can be arranged or arrangeable at the base unit. In an embodiment, the base unit and the testing connector can be repeatedly and removably connectable via the mechanical connector assembly.

An advantage can be a simple assembly and/or a simple disassembly.

In an embodiment, the test adapter can comprise an electrical connector assembly. The electrical connector assembly can comprise a first electrical connector element arranged at the testing connector and a second electrical connector element complementary to the first electrical connector element arranged at the base unit. The first electrical connector element can be operatively coupled to the at least one testing terminal. The second electrical connector element can be operatively coupled to the testing module.

An advantage can be a simple assembly and/or a simple disassembly.

In an embodiment, the base unit can further comprise a housing, wherein the housing is configured for housing the communication module and the testing module, wherein the housing comprises a first casing and a second casing which are repeatedly and removably connectable to each other, wherein each of the first casing and the second casing houses at least one of the communication module and the testing module.

The communication module and the testing module can be arranged in the housing of the base unit, particularly in the first and the second casing.

When connected to each other, the first casing and the second casing can close the housing.

The first casing and the second casing can be repeatedly and removably assemblable with each other. The housing can be repeatedly and removably disassemblable in the first casing and the second casing.

The first casing and/or the second casing can be configured for housing the essential modules.

The housing can comprise a mechanical connector assembly. The first casing and the second casing can be repeatedly and removably connectable via the mechanical connector assembly.

In an embodiment, the mechanical connector assembly can comprise a first mechanical connector element of the mechanical connector assembly arranged at the first casing and a corresponding second mechanical connector element of the mechanical connector assembly arranged at the second casing. The mechanical connector assembly can be arranged and configured such that in an assembled state, the first casing and the second casing are coupled. In the assembled state, the first casing and the second casing can be friction locked. In the assembled state, the first casing and the second casing can be positively coupled. In the assembled state, the first casing and the second casing can be fixed to each other by a fastening element (fixing element), e.g. a screw.

In an embodiment, the housing comprising the first casing and the second casing can also house at least one further functional module. In an embodiment, the housing consisting of the first casing and the second casing can also house at least one further functional module.

In an embodiment, in the extended state, the housing further comprises an intermediate portion, arranged between the first casing and the second casing and connecting the first casing and the second casing, wherein the intermediate portion is configured for housing of the further functional module.

In an embodiment, the intermediate portion can be configured for housing a plurality of further functional modules.

In an embodiment, the housing further comprises a plurality of intermediate portions arranged between the first casing and the second casing and connecting the first casing and the second casing. In an embodiment, each intermediate portion of the plurality of intermediate portions can be configured for housing of one further functional module.

The intermediate portion can comprise a further first mechanical connector element of the mechanical connector assembly and a further second mechanical connector element of the mechanical connector assembly. The further first mechanical connector element can be arranged and configured for assembling with the second mechanical connector element of the mechanical connector assembly arranged at the second casing. The further second mechanical connector element can be arranged and configured for assembling with the first mechanical connector element of the mechanical connector assembly arranged at the first casing.

The first casing can be attached to the intermediate portion via coupling of the first mechanical connector element and the further second mechanical connector element. The second casing can be attached to the intermediate portion via coupling of the second mechanical connector element and the further first mechanical connector element.

The connector elements of the intermediate portion and the connector elements of the first and second casings can establish the coupling.

An advantage can be that the base unit can be easily extendable.

An advantage can be that the reduction of the base unit (particularly from the extended state into the basic state) can be simplified.

In an embodiment, the base unit can be configured such that the arrangement of the testing module and the communication module (essential modules) in the first casing and/or the second casing can remain unaltered, when the further functional module is added. In an embodiment, the base unit can be configured such that the arrangement of the testing module and the communication module (essential modules) in the first casing and/or the second casing can remain unaltered, when the further functional module is removed. An advantage can be that the re-configuration of the base unit can be simplified. An advantage can be that only a partial removal or addition can be required, not a complete rebuild of the respective base unit. The can advantageously simplify the process. An advantage can be that time can be saved.

In an embodiment, the base unit in the basic state can further comprise an attachment unit configured for attachment of the base unit to the wiring board. In an embodiment, the base unit in the extended state can further comprise an attachment unit configured for attachment of the base unit to the wiring board. The attachment unit can be configured for repeated and removable connection with the wiring board. Via the attachment unit, the base unit can be attachable to the wiring board. The attachment of the base unit to the wiring board can mediate the attachment of the respective test adapter to the wiring board.

In an embodiment, the test adapter can be arrangeable such at the wiring board, particularly via the attachment unit, and the base unit and the testing connector can be connectable such to each other that the base unit and the testing connector can protrude from the same surface of the wiring board. The base unit and the testing connector can be arrangeable on the same side (surface) of the wiring board. An advantage can be that the handling can be simplified. The user can have an easy access to the test adapter. The user can have an easy access to the base unit. The user can have an easy access to the testing connector.

A second aspect of the invention relates to a method for re-configuring a base unit of a test adapter according to the invention, the method comprising the steps of
- providing the test adapter according to the invention, and
- adding at least one further functional module and/or removing at least one further functional module.

The method for re-configuring the base unit can be a method for extending the base unit. The method for re-configuring the base unit can be a method for reducing the base unit.

In an embodiment, the method can be for extending the base unit, wherein the base unit can be in the basic state, the method comprising providing the further functional module, and inserting the further functional module into the base unit thereby bringing the base unit to the extended state.

In an embodiment, the method can be for reducing the base unit, wherein the base unit can be in the extended state, the method comprising providing the test adapter according to the invention, wherein the base unit is in the extended state, and removing the further functional module, thereby bringing the base unit to the basic state.

In an embodiment, the method can be for further extending the base unit, wherein the base unit can be present in a first extended state comprising a first further functional module, the method comprising providing a second further functional module, and inserting the second further functional module into the base unit thereby bringing the base unit to the further extended state.

In an embodiment, the method can be for stepwise extending the base unit. Several further functional modules can be added one after the other. In an embodiment, the method can be for enlarged extending the base unit. Multiple further functional modules can be added in one common step.

In an embodiment, the method can be for further reducing the base unit, wherein the base unit can be present in the extended state comprising a first further functional module and a second further functional module, the method comprising removing the first further functional module, thereby bringing the base unit to the extended state comprising the second further functional module.

In an embodiment, the method can be for stepwise reducing the base unit. Several further functional modules can be removed one after the other. In an embodiment, the method can be for enlarged reducing the base unit. Multiple further functional modules can be removed in one common step.

An advantage can be that the test adapter can be easily adjusted to the specific requirements.

A further aspect of the invention relates to the use of the test adapter according to the invention, whereby the base unit can be re-configured by adding at least one further functional module and/or removing at least one further functional module.

The test adapter can be used for testing a wire harness. The test adapter can be used for testing the wire harness during the assembly process. In an embodiment, the test adapter can be used for in-line testing the wire harness.

In an embodiment, a test adapter can be used, wherein the base unit can be in the basic state, such that the test adapter can be configured for passing an electric testing signal to the at least one testing terminal and/or for obtaining an electric testing signal from the at least one testing terminal.

In an embodiment, a test adapter can be used, wherein the base unit can be in the extended state, such that the test adapter can be configured for performing the functionality of the basic state (particularly such that the test adapter can be configured for passing an electric testing signal to the at least one testing terminal and/or for obtaining an electric testing signal from the at least one testing terminal), and additionally such that the test adapter can be configured to execute an additional functioning using the further functional module.

In an embodiment, a test adapter can be used, wherein the base unit can be in the extended state, such that the test adapter can be configured for performing the functionality of the basic state (particularly such that the test adapter can be configured for passing an electric testing signal to the at least one testing terminal and/or for obtaining an electric testing signal from the at least one testing terminal), and additionally such that the test adapter can be configured to execute an additional testing using the further functional module.

In an embodiment, a test adapter can be used, wherein the base unit can be in the extended state, such that the test adapter can be configured for performing the functionality of the basic state (particularly such that the test adapter can be configured for passing an electric testing signal to the at least one testing terminal and/or for obtaining an electric testing signal from the at least one testing terminal), and additionally such that the test adapter can be configured to be powered using the further functional module. The test adapter can be configured to additionally power connected test adapters.

In an embodiment, a test adapter can be used, wherein the base unit can be in the extended state, such that the test adapter can be configured for passing an electric testing signal to the at least one testing terminal and/or for obtaining an electric testing signal from the at least one testing terminal, and wherein the test adapter can be further configured for analysis of optical fibres using the light source and/or analysis of a quality of a wire connection using the force sensor and/or analysis of a quality of a wire fixation using the force sensor.

In an embodiment, a force, particularly a tensile force can be applied to a connection, for instance the connection between the wire and the wire terminal. The force sensor can be arranged and configured to determine the force with which the connection can be pulled without the connection loosening. In an embodiment, the force application can be stopped, when the sensor detects that a pre-defined threshold force is applied.

In an embodiment, the further functional module can be configured for analysing sensor data. The further functional module can be configured for comparing sensor data with the applied force.

Further features and embodiments of the present invention are described in the following with reference to the Figures, wherein:
- Fig. 1: shows a schematic illustration of a wire harness,
- Fig. 2: shows a schematic illustration of an embodiment of a test adapter comprising a base unit in the basic state,
- Fig. 3: shows a schematic explosion view of an embodiment of a base unit in the basic state,
- Fig. 4: shows a schematic illustration of an embodiment of a test adapter comprising a base unit in the extended state,
- Fig. 5: shows a schematic explosion view of an embodiment of a test adapter with a base unit in the extended state,
- Fig. 6: shows a schematic explosion view of an embodiment of a base unit in the extended state
- Fig. 7: shows a schematic illustration of an embodiment of a test adapter comprising a base unit in the extended state,
- Fig. 8: shows a schematic illustration of an assembly board with a plurality of test adapters,
- Fig. 9: shows a schematic flowchart of an embodiment of a method using one exemplary test adapter with a base unit in basic state and one exemplary test adapter with a base unit in an extended state,
- Fig. 10: shows exemplary schematic flowcharts for extending the base unit, and
- Fig. 11: shows exemplary schematic flowcharts for reducing the base unit.

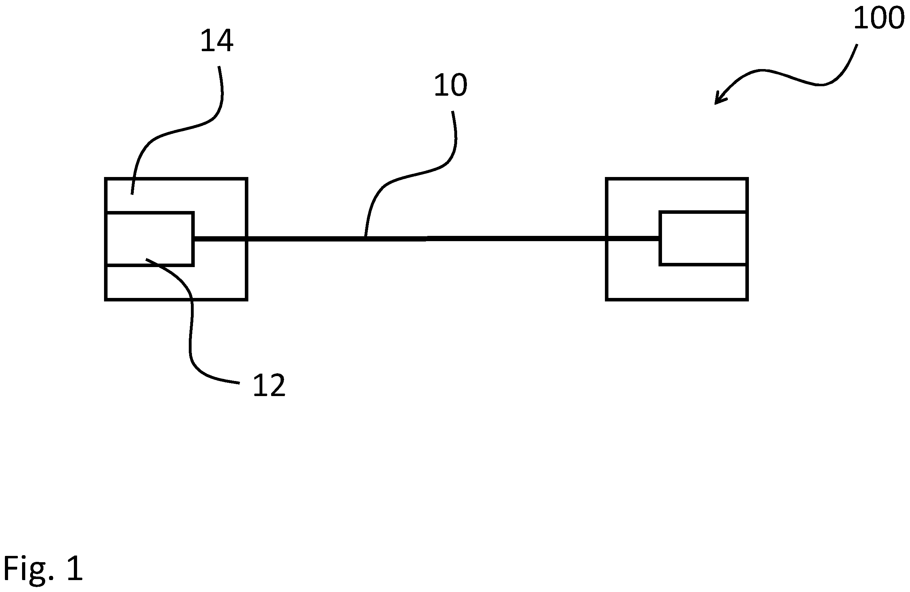

Figure 1 shows a schematic illustration of a wire harness 100. The wire harness 100 can comprise a wire 10. The wire harness 100 can comprise a plurality of wires 10. The wire harness 100 can comprise a wiring connector 14. The wire harness 100 can comprise a plurality of wiring connectors 14. The wiring connector 14 can comprise a wire terminal 12. Each wiring connector 14 can comprise at least one wire terminal 12. Each wiring connector 14 can comprise a plurality of wire terminals 12. The wire terminal 12 can be associated with the respective wire 10. Each wire terminal 12 can be associated with a respective wire 10. The wire 10 can connect a first wiring connector 14 and a second wiring connector 14.

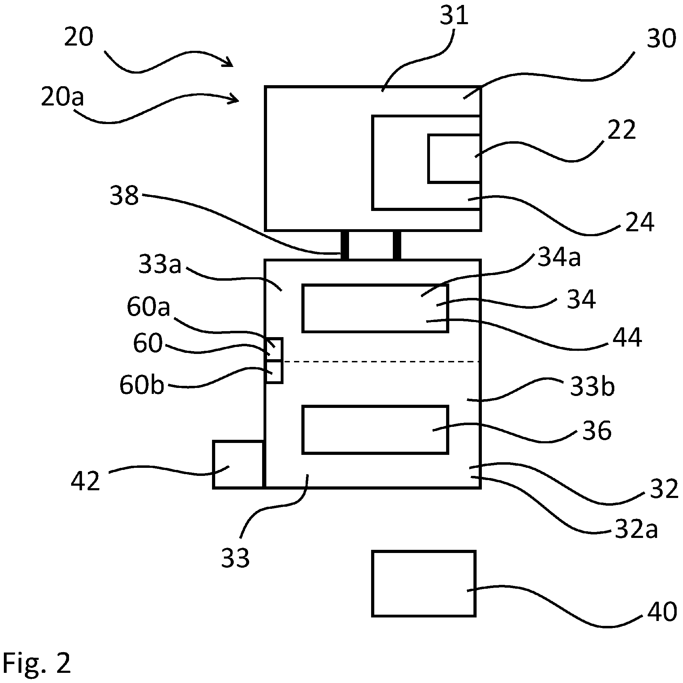

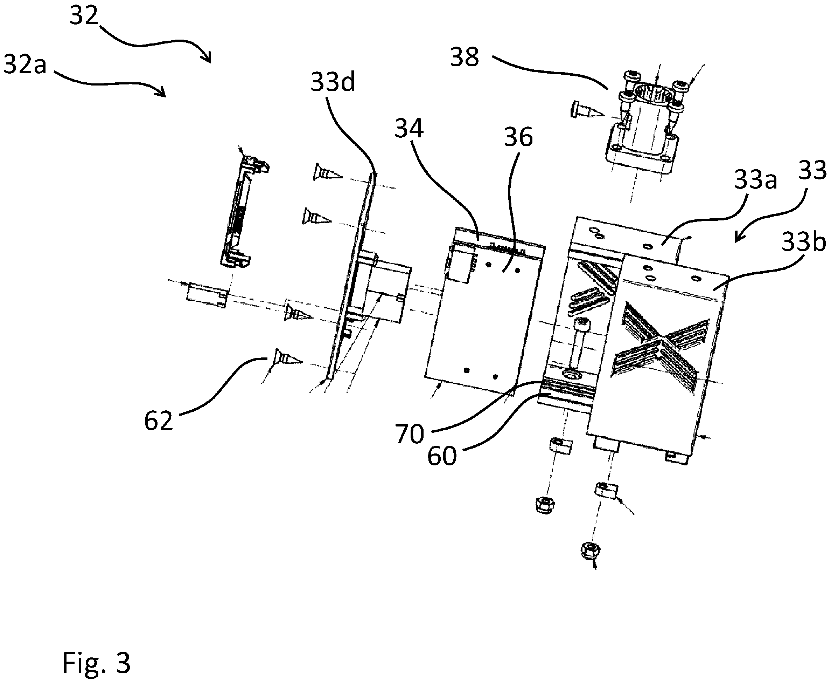

In Figure 2, an illustration of an exemplary embodiment of a test adapter 20, 20a is provided wherein the base unit 32, 32a of the test adapter 20, 20a is in the basic state. In Figure 3, an explosive view of an embodiment of a base unit 32, 32a in the basic state is provided.

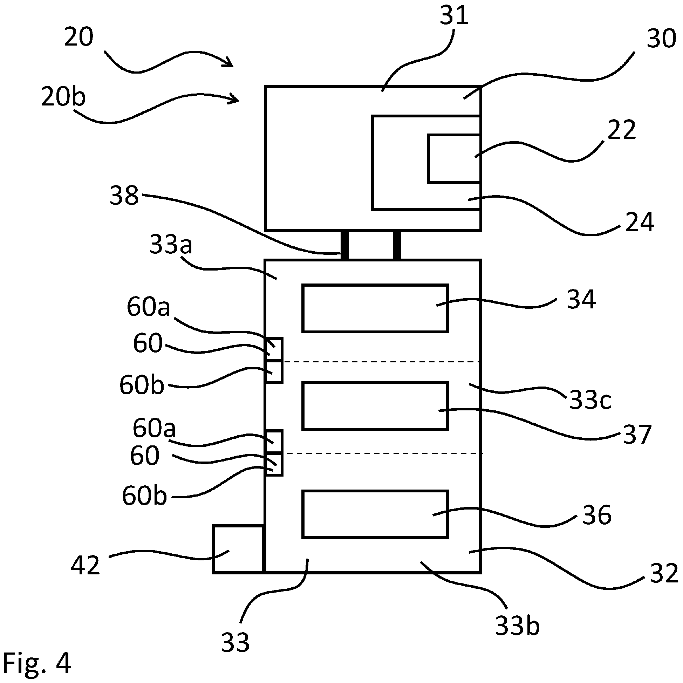

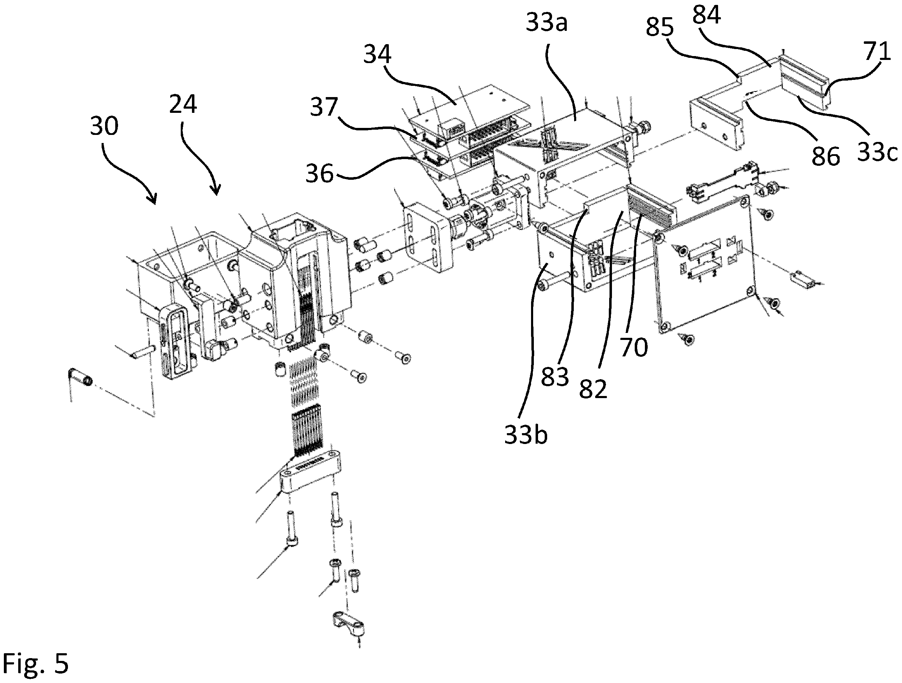

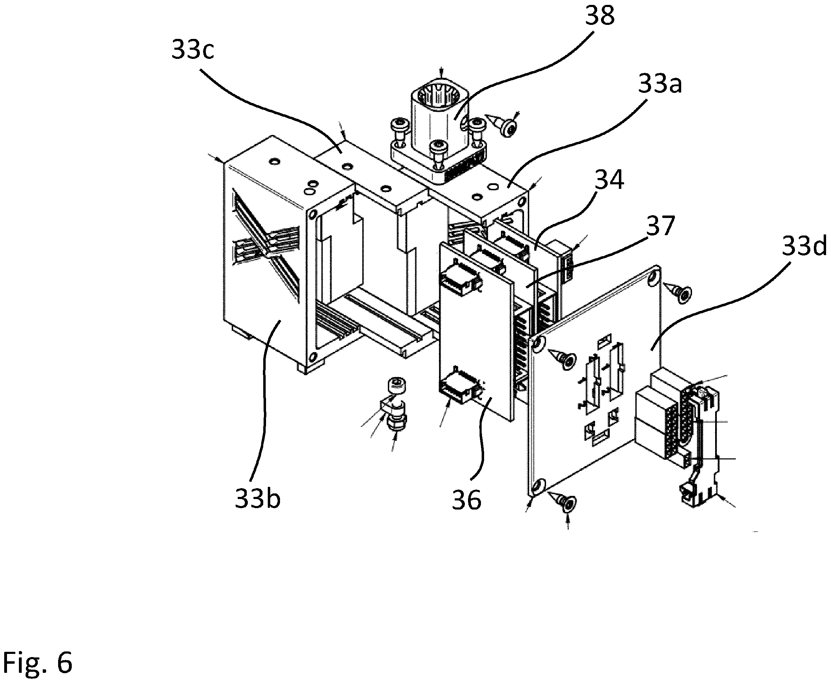

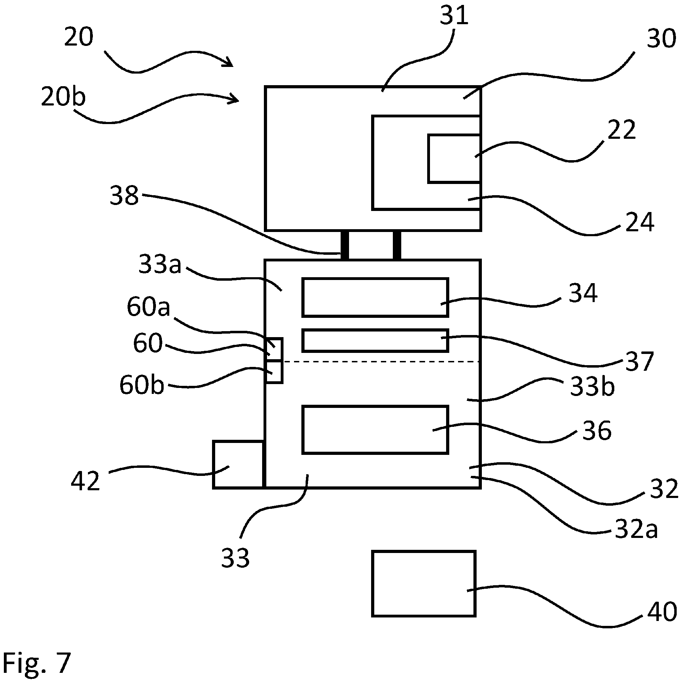

In Figure 4, an illustration of an exemplary embodiment of a test adapter 20, 20b is provided wherein the base unit 32, 32b of the test adapter 20, 20b is in the extended state. In Figure 5, an explosive view of an embodiment of a test adapter 20, 20b with a base unit 32, 32b in the extended state is given. In Figure 6, an explosive view of an embodiment of a base unit 32, 32b in the extended state is provided. In Figure 7, an illustration of a further exemplary embodiment of a test adapter 20, 20b is provided wherein the base unit 32, 32b of the test adapter 20, 20b is in the extended state.

The test adapter 20, 20a, 20b can comprise a plug unit 30. The plug unit 30 can be attached to the base unit 32, 32a, 32b. The plug unit 30 can be connected to the base unit 32, 32a, 32b. The plug unit 30 can be attached to the base unit 32, 32a, 32b via a coupling assembly 38. In an embodiment, the plug unit 30 can be reversibly and repeatedly attached to the base unit 32, 32a, 32b via the coupling assembly 38. The plug unit 30 can comprise a housing 31. The plug unit 30 can comprise a testing connector 24. The plug unit 30 can comprise a testing terminal 22. The plug unit 30 can comprise a plurality of testing terminals 22.

The testing connector 24 can comprise one testing terminal 22. The testing connector 24 can comprise a plurality of testing terminals 22.

The testing connector 24 can be connected to the base unit 32, 32a, 32b. In an embodiment, the testing connector 24 can be reversibly and repeatedly attached to the base unit 32, 32a, 32b. In an embodiment, the testing connector 24 can be reversibly and repeatedly attached to the base unit 32, 32a, 32b via the coupling assembly 38.

The housing 31 of the plug unit 30 can be configured for housing the testing connector 24. The coupling assembly 38 can be arranged at the housing 31 of the plug unit 30. An element of the coupling assembly 38 can be arranged at the housing 31 of the plug unit 30. The element of the coupling assembly 38 can be integral with the housing 31 of the plug unit 30.

The test adapter 20, 20a, 20b can comprise the base unit 32, 32a, 32b.

The base unit 32, 32a can be present in the basic state (see Figures 2 and 3). The base unit 32, 32a, 32b can comprise the testing module 34. The testing module 34 can be arranged in the base unit 32, 32a, 32b. In an embodiment, the testing module 34 can comprise a test point card 34a. In an embodiment, the testing module 34 can comprise a processing unit 44.

The base unit 32, 32a, 32b can comprise a communication module 36. The communication module 36 can be configured for wireless communication with a wireless communication hub 40 The communication module 36 can be communicatively connected with the wireless communication hub 40.

The base unit 32, 32a can comprise an attachment unit 42. The attachment unit 42 can be configured for attaching the base unit 32, 32a to the wiring board.

The housing 33 of the base unit 32, 32a, 32b can be configured for housing the testing module 34 and the communication module 36. The housing 33 of the base unit 32, 32a, 32b can comprise a first casing 33a. The housing 33 of the base unit 32, 32a, 32b can comprise a second casing 33b. In an embodiment, the housing 33 can be attached to a cover 33d. In an embodiment, the housing 33 can further comprise the cover 33d. In an embodiment, the first casing 33a and the second casing 33b can be attached to the cover 33d.

The first casing 33a and the second casing 33b can be slidable together (particularly see Fig. 3). The first casing 33a and the second casing 33b can be directly connectable to each other (particularly see Figures 2 and 3 (basic state) and Figure 7 (extended state)). In an embodiment, the first casing 33a and the second casing 33b can be connected to each other via a mechanical connector assembly 60 (particularly see Figure 2 (basic state) and Figure 7 (extended state)).

The mechanical connector assembly 60 can comprise a first mechanical connector element 60a arranged at the first casing 33a. The mechanical connector assembly 60 can comprise a corresponding second mechanical connector element 60b arranged at the second casing 33b. The mechanical connector assembly 60 can comprise a groove. The mechanical connector assembly 60 can comprise a corresponding tongue.

In an embodiment, the mechanical connector assembly 60 can comprise the cover 33d. In an embodiment, the first casing 33a and the second casing 33b can be fixed to the cover 33d (particularly see Figure 3). The cover 33d can be fixed to the first casing 33a and/or the second casing 33b through a fastening element 62. The fastening element 62 can be a screw.

In an embodiment, the mechanical connector assembly 60 can comprise the coupling assembly 38. In an embodiment, the coupling assembly 38 can be fixed to the first casing 33a and the second casing 33b (particularly see Figure 3). In an embodiment, at least one unit of the coupling assembly 38 can be fixed to the first casing 33a and the second casing 33b (particularly see Figure 3).

The first casing 33a can be configured for housing the testing module 34. The second casing 33b can be configured for housing the testing module 34. The first casing 33a can be configured for housing the communication module 36. The second casing 33b can be configured for housing the communication module 36. In an embodiment, the testing module 34 can be arranged in the first casing 33a. In an embodiment, the communication module 36 can be arranged in the second casing 33b. In an embodiment, the testing module 34 can be reversibly arrangeable (particularly repeatedly and reversibly arrangeable) in the first casing 33a. In an embodiment, the communication module 36 can be reversibly arrangeable (particularly repeatedly and reversibly arrangeable) in the second casing 33b.

The first casing 33a and/or the second casing 33b can comprise a slot 70. The slot 70 can be arranged and configured such that the testing module 34 can be insertable in the slot 70. The slot 70 can be arranged and configured such that the communication module 36 can be insertable in the slot 70.

In an embodiment, the first casing 33a and/or the second casing 33b can comprise multiple slots 70. Each slot 70 can be arranged and configured such that the testing module 34 can be insertable in one of the slots 70. Each slot 70 can be arranged and configured such that the communication module 36 can be insertable in one of the slots 70. An advantage can be a simple arrangement of the testing module 34 and/or the communication module 36 within the housing.

The respective essential module can be easily inserted. The respective essential module can be easily removed.

In an embodiment, the first casing 33a and/or the second casing 33b can comprise multiple slots 70, wherein at least one of these slots can be arranged and configured such that the further functional module 37 is insertable in the respective slot 70. In an embodiment, the first casing 33a can be configured for housing the testing module 34 and the further functional module 37 (see particularly Figure 7).

In an embodiment, the further functional module 37 can be reversibly arrangeable (particularly repeatedly and reversibly arrangeable) in the first casing 33a. In an embodiment, the further functional module 37 can be reversibly arrangeable (particularly repeatedly and reversibly arrangeable) in the second casing 33b.

An advantage can be a simple arrangement of the further functional module 37 within the housing. The further functional module 37 can be easily inserted. The further functional module 37 can be easily removed.

In an embodiment, the back cover 80 of the first casing 33a can comprise a step 81. In an embodiment, the back cover 82 of the second casing 33b can comprise a complementary corresponding step 83 (also see Figures 5 and 6). The alignment of the first casing 33a and the second casing 33b relative to each other can be improved.

The base unit 32, 32b can be present in the extended state (see Figures 4 to 7). The features of the base unit 32, 32a in the basic state can also be present in the base unit 32, 32b in the extended state. In the extended state, the base unit 32, 32b can comprise the essential modules, particularly the testing module 34 and the communication module 36.

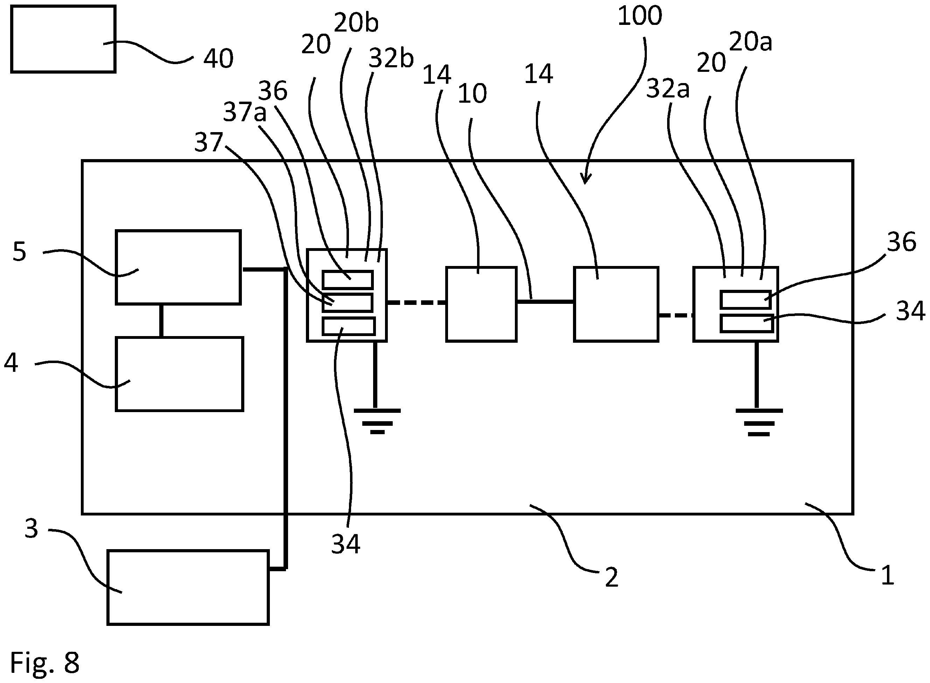

In the extended state, the base unit 32, 32b can comprise at least one further functional module 37 in addition. The further functional module 37 can comprise or consist of a power source 37a (also see Figure 8). The further functional module 37 can comprise or consist of a further testing module 34a (see particularly Figures 5 and 6). The further functional module 37 can comprise or consist of a further test point card.

In the extended state, the base unit 32, 32b can comprise the first casing 33a and the second casing 33b. In an embodiment, the first casing 33a can be configured for housing the testing module 34 and the further functional module 37 (see particularly Figure 7). In an embodiment, the second casing 33b can be configured for housing the communication module 36 and the further functional module 37.

In the extended state, the base unit 32, 32b can comprise an intermediate portion 33c of the housing 33 (see particularly Figures 4 to 6). The intermediate portion 33c can be arranged between the first casing 33a and the second casing 33b. The intermediate portion 33c can be linked to the first casing 33a and to the second casing 33b. In an embodiment, the intermediate portion 33c can be connected with the first casing 33a through a mechanical connector assembly 60. In an embodiment, the intermediate portion 33c can be connected with the second casing 33b through a mechanical connector assembly 60. The intermediate portion 33c can expand (enlarge, scale up) the housing 33. In the extended state, the housing 33 of the base unit 32, 32b can be greater than the housing 33 of the base unit 32, 32a in the basic state.

In an embodiment, the back cover 84 of the intermediate portion 33c can comprise a first step 85 and a second step 86, which can be complementary corresponding to the step 81 and 83 of the first casing 33a and the second casing 33b. The alignment of the casings 33a, 33b and the intermediate portion 33c can be improved.

The further functional module 37 can be housed in the intermediate portion 33c. The further functional module 37 can be arrangeable in the intermediate portion 33c. The intermediate portion 33c can comprise a further slot 71. The further slot 71 can be arranged and configured to receive the further functional module 37.

An advantage can be a simple arrangement of the further functional module 37 within the intermediate portion 33c. The further functional module 37 can be easily inserted. The further functional module 37 can be easily removed.

In Figure 8, an embodiment of an assembly board 1 (wiring board 1) is illustrated. The assembly board 1 can comprise a metal plate 2. The assembly board 1 can comprise a metal grid. The assembly board 1 can provide the common ground.

In the illustrated example, a plurality of test adapters 20, 20a, 20b can be arranged at the wiring board 1. The plurality of test adapters 20, 20a, 20b can comprise one test adapter 20b with the base unit 32, 32b in the extended state (master adapter 20b). The plurality of test adapters 20, 20a, 20b can comprise one test adapter 20a with the base unit 32, 32a in the basic state (satellite test adapter 20a). The plurality of test adapters 20, 20a, 20b can comprise one master adapter 20b and one satellite adapter 20a.

The test adapter 20a with the base unit 32, 32a in the basic state can be grounded at the wiring board 1. In the illustrated example, the test adapter 20a with the base unit 32, 32a in the basic state is not directly powered by a respective power source.

The test adapter 20b with the base unit 32, 32b in the extended state can comprise a power source 37a. The master test adapter 20b can be powered by the power source 37a. The master test adapter 20b can directly be powered by the power source 37a.

The illustrated embodiment can comprise a further power supply 3 that can provide power to a communication hub 5. The further power supply 3 can also power a human-machine-interface (HMI) 4. The HMI 4 can be operatively coupled with the communication hub 5. The communication hub 5 can be configured for wireless communication. The communication hub 5 can be configured for wireless communication with the communication module 36. The communication hub 5 can be configured for wireless communication with the communication module 36 of the master test adapter 20b and/or the satellite test adapter 20a.

In the illustrated example one wiring connector 14 of the wiring harness 100 can be connected with the master test adapter 20b. In the illustrated example one wiring connector 14 of the wiring harness 100 can be connected with the satellite test adapter 20a. The wiring connectors 14 can be connected via the wire 10.

In an embodiment, when the master test adapter 20b is powered by the power source 37a, power can be transmitted from the power source 37a of the master test adapter 20b via the wire 10 of the wire harness 100 to the satellite test adapter 20a. The transmitted power can power the satellite test adapter 20a. The power of the master test adapter 20b can be used to indirectly power the satellite test adapter 20a. In an embodiment, the power transmitted via the wire 10 from the master test adapter 20b to the satellite test adapter 20a can power the testing module 34 of the satellite test adapter 20a. In an embodiment, the power transmitted via the wire 10 from the master test adapter 20b to the satellite test adapter 20a can power the communication module 36 of the satellite test adapter 20a. In an embodiment, the communication module 36 of the satellite test adapter 20a can output an output signal, when the satellite test adapter 20a is powered (particularly properly powered) via the master test adapter 20b. The output signal can be a visual signal. The output signal can be an acoustic signal. In an embodiment, the communication module 36 is configured for wireless communication with the wireless communication hub 40 and can send information, e.g. the powering status, to the wireless communication hub 40.

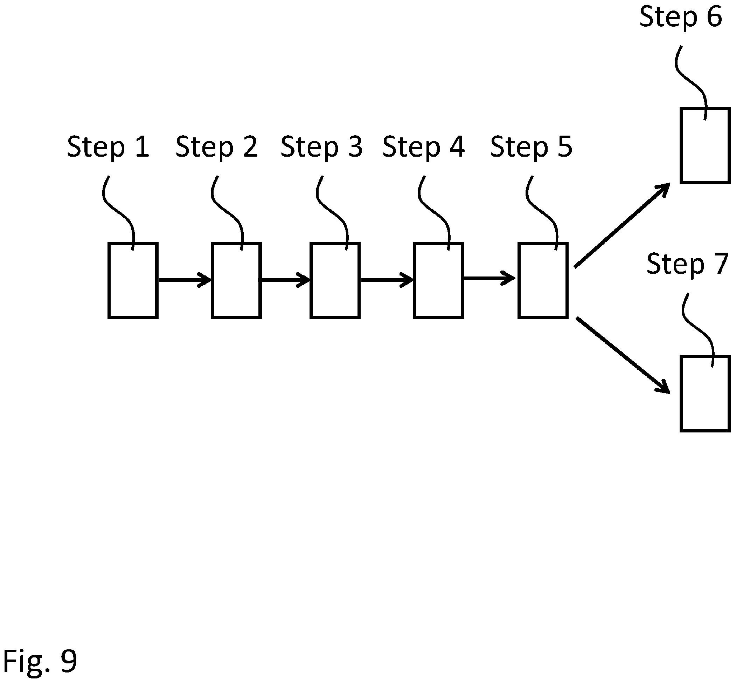

In Figure 9, a schematic flowchart of an exemplary method using one master test adapter 20b and one satellite test adapter 20a is given.

The master test adapter and the satellite test adapter can be provided. The master test adapter and the satellite test adapter can be arranged on the wiring board (step 1), particularly on the common ground. The wire harness can be provided. The wire harness can comprise the wire and wiring connectors with wire terminals. The wire harness can be connected with the master test adapter and the satellite test adapter. In particular, the first electric wire terminal can be connected with the master test adapter and the second electric wire terminal can be connected with the testing terminal of the satellite test adapter (step 2). The master test adapter can be powered (step 3). The powered master test adapter can power the satellite test adapter (step 4). The electrical connection between the master test adapter and the satellite test adapter can be tested (step 5). When an appropriate electrical connection can be detected, for instance when the satellite test adapter is (indirectly) powered, the satellite test adapter can output a signal output, e.g. output an approval signal (step 6). When an erroneous electrical connection can be detected, for instance when the satellite test adapter is unpowered, no signal output (e.g. no approval signal) can be sent by the satellite test adapter (step 7). When the appropriate electrical connection can be detected, a further wire can be connected and tested considering the respective steps of the method. When an erroneous electrical connection can be detected, the particular connection can be examined and, for instance, the respective wire can be replaced.

In an embodiment, testing of the electrical connection can include emitting the electric testing signal from the master test adapter through the wire. The electric testing signal from the master test adapter can power the satellite test adapter.

In an embodiment, the method can comprise
- providing a plurality of test adapters, comprising a master test adapter comprising a power supply and a satellite test adapter, wherein each test adapter comprises at least one testing terminal configured for being electrically connected to the at least one electric wire terminal of the respective wiring connector,
- connecting a first electric wire terminal of a first wire to the testing terminal of the master test adapter,
- connecting a second electric wire terminal of the first wire in the testing terminal of the satellite test adapter,
- powering, through the power supply, the master test adapter,
- powering, by the master test adapter, the satellite test adapter through the first wire, and
- testing an electrical connection between the master test adapter and the satellite test adapter through the first wire.

The master testing adapter can be powered by the power supply. The power supply can comprise a battery. The power supply can comprise a rechargeable battery. The master testing adapter can be configured to emit power towards the satellite testing adapter via the first wire. In an embodiment, the master test adapter can power the satellite test adapter through the first wire. In an embodiment, an electrical connection between the master test adapter and the satellite test adapter through the first wire can be tested. In particular, the electrical connection established between the master test adapter and the satellite test adapter by the first wire can be tested after connection and powering the master testing adapter. In an embodiment, the connection between the master testing adapter and the satellite test adapter can be tested by inspecting whether the powering of the satellite test adapter is successful.

A successful powering of the satellite test adapter can indicate that the respective connecting cable (wire) is error-free. A successful powering of the expected testing terminal of the satellite test adapter can indicate that the respective connecting cable (wire) is error-free. A successful powering of the satellite test adapter can indicate that the respective terminals are error-free. A successful powering of the expected testing terminal of the satellite test adapter can indicate that the respective terminals are error-free. The erroneous signal can be a detected when power is supplied from the master test adapter to an unexpected testing terminal of the satellite test adapter.

In an embodiment, the method can be configured for in-line testing of the wire harness. In an embodiment, the method can be configured for real time testing of the wire harness. The wire harness, particularly the connections within the wire harness, can be tested during assembly of the wire harness.

In an embodiment, the testing of the electrical connection can include emitting an electric testing signal from the master test adapter through the first wire, and powering, with the electric testing signal from the master test adapter, the satellite test adapter. In an embodiment, the electrical testing signal received from the master can be used to turn on the electronics in satellite test adapter. In an embodiment, the received electrical testing signal can be used to power the testing module of the satellite test adapter. In an embodiment, the received electrical testing signal can be used to power the communication module of the satellite test adapter.

In an embodiment, the respective method can further comprise analysing, with an analysis device, the signal output from the satellite test adapter using the power provided by the master test adapter.

In an embodiment, the method can further comprise connecting a plurality of satellite test adapters with the master test adapter, and powering, with the master test adapter, each satellite test adapter of the plurality of satellite test adapters. In an embodiment, the plurality of satellite test adapters can be connected with the master test adapter in an assembly order. In an embodiment, each satellite test adapter of the plurality of satellite test adapters can be powered by the master test adapter in the assembly order.

In an embodiment, the satellite test adapters can comprise an energy storage unit, e.g. a capacitor, to store the power transmitted by the master test adapter.

In an embodiment, the test adapters can be used in the context of the method further comprising the steps of providing a common ground, arranging the plurality of test adapters electrically connectable to the common ground, and closing an electrical circuit via the common ground, the master test adapter and the satellite test adapter, when powering the satellite test adapter by the master test adapter, particularly when emitting the electric testing signal from the master test adapter to the satellite test adapter.

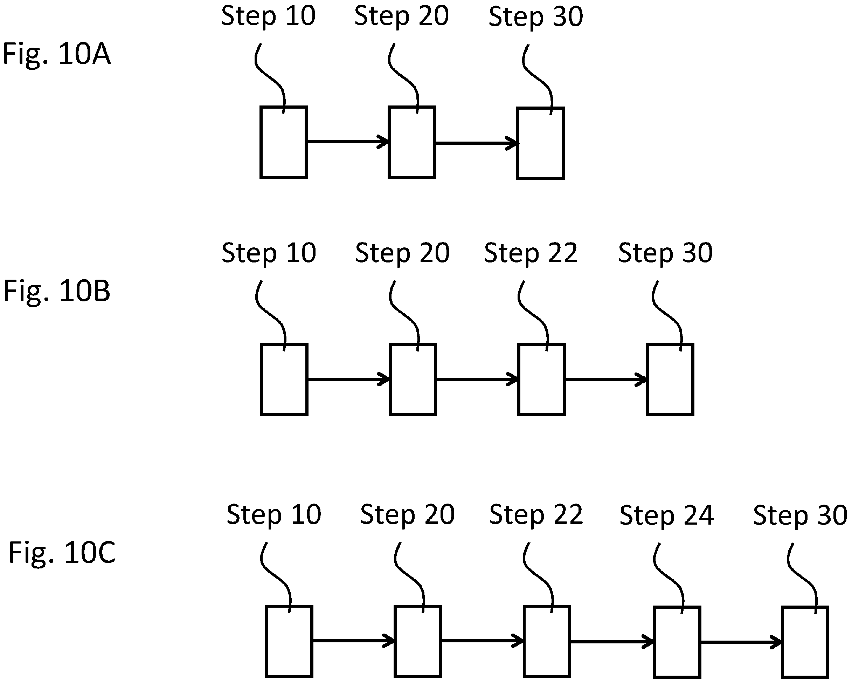

In Figure 10A, a flow scheme of an exemplary extension of the base unit is illustrated. In the illustrated embodiment, the base unit in the basic state can be provided (step 10). Further, the further functional module can be provided (step 20). The further functional module can be inserted into the base unit (step 30).

In an embodiment (Figure 10B), before the further functional module can be inserted (step 30), the housing of the base unit can be opened (step 22). In an embodiment, for opening, the housing of the base unit can be disassembled. In particular, the first casing and the second casing can be disconnected. The further functional module can be inserted. In an embodiment, the further functional module can be inserted in the first casing or in the second casing. After insertion, the housing can be closed. In an embodiment, the first casing and the second casing can be connected.

In an embodiment (Figure 10C), before the further functional module can be inserted, the housing of the base unit can be opened (step 22). In particular, the first casing and the second casing can be disconnected. An intermediate portion can be provided (step 24). The further functional module can be arranged in the intermediate portion. The further functional module can be arrangeable in the intermediate portion. The intermediate portion can be connected to the first casing and the second casing.

In an embodiment, providing the base unit in the basic state, can comprise providing the housing, particularly providing the first casing and the second casing. The first casing and the second casing can be connected, particularly via the mechanical connector assembly. The testing module can be arranged in the housing. The communication module can be arranged in the housing. The housing can be closed.

In an embodiment, providing the base unit in the basic state, can comprise a physical assembly step. The housing, particularly the first casing and the second casing, can be provided. The first casing and the second casing can be connected, particularly via the mechanical connector assembly. The testing module can be arranged in the housing. The testing module can comprise a test point card. The communication module can be arranged in the housing. The communication module can comprise a wireless card.

In an embodiment, the testing module can comprise a processing unit. The testing module can comprise a printed circuit board (PCB). In an embodiment, the testing module can comprise a single-board computer. In an embodiment, the testing module can comprise a Raspberry Pi.

The wireless card can be connected with the processing unit. In an embodiment, the wireless card can be connected with the Raspberry Pi.

In an embodiment, a software can be executed on the processing unit. In an embodiment, a SD card can be prepared with the software. The SD card can be placed into the respective slot on the control board.

In an embodiment, the software can be executed on the processing unit (e.g. on the Raspberry Pi). In an embodiment, a SD card can be prepared with Raspberry Pi software. The SD card can be placed into the Raspberry Pi slot on the control board.

The software can define properties of the test adapter.

In an embodiment, a connectivity check can be performed. It can be checked whether the test adapter is correctly connected and operational. In an embodiment, a final assembly check can be performed. It can be verified whether all components are securely mounted and/or whether all connections are stable.

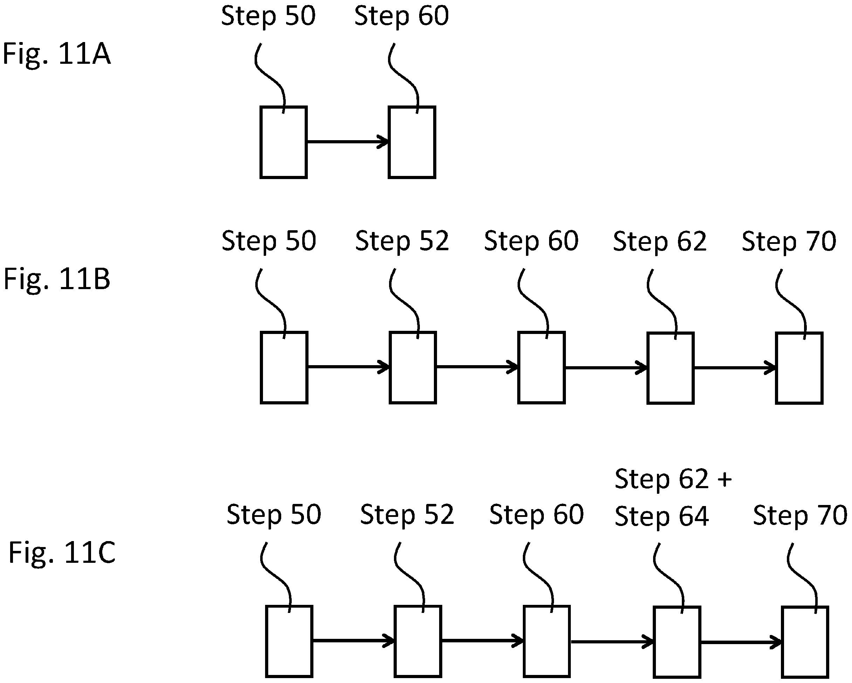

In Figure 11A, a flow scheme of an exemplary reduction of the base unit is illustrated. In the illustrated embodiment, the base unit in the extended state can be provided (step 50). The further functional module can be removed (step 60).

In an embodiment (Figure 11B), before the further functional module can be removed (step 60), the housing of the base unit can be opened (step 52). In an embodiment, for opening, the housing of the base unit can be disassembled. In an embodiment, the first casing and the second casing can be disconnected. After removal of the further functional module (step 60), the first casing and the second casing can be connected (step 62). The base unit can be brought in the basic state (step 70).

In an embodiment (Figure 11C), before the further functional module can be removed, the housing of the base unit can be opened (step 52). In an embodiment, the first casing, the second casing and the intermediate portion can be disconnected. The further functional module (step 60) and the intermediate portion can be removed (step 64). The first casing and the second casing can be connected (step 62). The base unit can be brought in the basic state (step 70).

## Claims

1. A test adapter for testing a wire harness on a wiring board,
the wiring harness comprising a plurality of wires connected between a plurality of wiring connectors, the wiring connectors comprising respectively at least one electric wire terminal associated with at least one of the wires,
the test adapter comprising a base unit and
a testing connector, the testing connector being configured to receive a respective one of the wiring connectors, the testing connector having at least one testing terminal configured for being electrically connected to the at least one electric wire terminal of the respective wiring connector,
wherein the base unit is configured to be assembled in a basic state and in an extended state,
wherein in the basic state the base unit comprises:
- a communication module, wherein the communication module is configured for communication with a communication hub, and
- a testing module connected to the at least one testing terminal for passing an electric testing signal to the at least one testing terminal and/or for obtaining an electric testing signal from the at least one testing terminal,
wherein in the extended state, the base unit comprises the communication module, the testing module, and at least one further functional module.

2. The test adapter according to claim 1, wherein the at least one further functional module is at least one of: a further testing module, a power source, a functional testing unit configured for performing a further functional test on the at least one electric wire terminal and/or on the at least one of the wires.

3. The test adapter according to claim 1 or 2, wherein the electric testing signal is selected from a constant voltage, a non-constant voltage, a transient voltage, a periodic voltage, a switching on and off of a pre-selected voltage, a switching on of a pre-selected voltage for a pre-determined duration and a switching of after the pre-determined duration.

4. The test adapter according to one of claims 1 to 3, wherein the communication module and the communication hub are configured for wireless communication.

5. The test adapter according to one of claims 1 to 4, wherein the power source comprises a battery, particularly a re-chargeable battery, and/or
wherein the power source comprises a capacitor.

6. The test adapter according to one of claims 1 to 5, wherein the base unit is configured to receive and/or analyse data determined by the further functional module, particularly wherein the testing module and/or the further testing module is configured for receiving and/or analysing data determined by the further functional module.

7. The test adapter according to one of claims 1 to 6, wherein the further functional module comprises at least one of a force sensor, a tensile force sensor, a light source, an analogue input unit

8. The test adapter according to one of claims 1 to 7, wherein the base unit is repeatedly and reversibly transferable from the basic state to the extended state, and/or wherein the base unit is repeatedly and reversibly connectable to the testing connector.

9. The test adapter according to one of claims 1 to 8, wherein the base unit further comprises a housing, wherein the housing is configured for housing the communication module and the testing module,
wherein the housing comprises a first casing and a second casing which are repeatedly and removably connectable to each other, wherein each of the first casing and the second casing houses at least one of the communication module and the testing module.

10. The test adapter according to one of claims 1 to 9, wherein in the extended state, the housing further comprises an intermediate portion, arranged between the first casing and the second casing and connecting the first casing and the second casing, wherein the intermediate portion is configured for housing of the further functional module.

11. A method for re-configuring a base unit of a test adapter according to one of the claims 1 to 10,
- providing the test adapter according to one of the claims 1 to 10, and
- adding at least one further functional module and/or removing at least one further functional module.

12. The method according to claim 11, wherein the method is for extending the base unit, wherein the base unit is in the basic state, the method comprising:
- providing the further functional module, and
- inserting the further functional module into the base unit thereby bringing the base unit to the extended state,
and/or
wherein the method is for reducing the base unit, wherein the base unit is in the extended state, the method comprising:
- providing the test adapter according to one of the claims 1 to 10, wherein the base unit is in the extended state, and
- removing the further functional module, thereby bringing the base unit to the basic state.

13. A use of the test adapter according to one of the claims 1 to 10,
whereby the base unit is re-configured by adding at least one further functional module and/or removing at least one further functional module.

14. The use of the test adapter according to claim 13,
wherein the base unit is in the basic state, such that the test adapter is configured for passing an electric testing signal to the at least one testing terminal and/or for obtaining an electric testing signal from the at least one testing terminal,

15. The use of the test adapter according to claim 13 or 14,
wherein the base unit is in the extended state, such that the test adapter is configured for passing an electric testing signal to the at least one testing terminal and/or for obtaining an electric testing signal from the at least one testing terminal,
wherein the test adapter is further configured for analysis of optical fibres using the light source and/or analysis of a quality of a wire connection using the force sensor and/or analysis of a quality of a wire fixation using the force sensor.
